Europäisches Patentamt

(19) European Patent Office

Office européen des brevets

(11) Publication number: **0 087 317**

**B1**

(12) **EUROPEAN PATENT SPECIFICATION**

(45) Date of publication of patent specification: **08.07.87**          (51) Int. Cl.⁴: **A 23 J 3/00,** A 23 L 1/04

(21) Application number: **83300924.4**

(22) Date of filing: **22.02.83**

(54) Cold water soluble gelatin and process.

(30) Priority: **22.02.82 US 350557**
**22.02.82 US 350558**
**22.02.82 US 350559**

(43) Date of publication of application:
**31.08.83 Bulletin 83/35**

(45) Publication of the grant of the patent:
**08.07.87 Bulletin 87/28**

(84) Designated Contracting States:
**AT BE CH DE FR GB IT LI LU NL SE**

(56) References cited:
**GB-A-1 419 996**
**US-A-3 362 830**
**US-A-3 927 221**

(73) Proprietor: **NABISCO BRANDS INC.**
**Nabisco Brands Plaza**
**Parsippany New Jersey 07054 (US)**

(72) Inventor: **Brown, Gary M.**
**213 Clapboard Ridge Road**
**Danbury CT 06810 (US)**
Inventor: **Bosc, Peter M.**
**4 Bonny Road**
**Brookfield Center CT 06805 (US)**
Inventor: **Danielson, Robert L.**
**21 Whisconier Village**
**Brookfield Center CT 06805 (US)**

(74) Representative: **Thomas, Roger Tamlyn et al**
**D. Young & Co. 10 Staple Inn**
**London WC1V 7RD (GB)**

# 0 087 317

**Description**

Technical field

The present invention relates to cold water soluble gelatin; and, particularly, to an improved cold water soluble gelatin product and a process for preparing it.

Gelatin is a widely used food ingredient. It has the ability to thicken or otherwise improve the texture of a variety of liquid products and also to set to a heat reversible gel which is useful in preparing products such as gelatin desserts. In products such as salad dressings, it aids in suspending particulate ingredients, and in frozen products such as ice cream it has the ability to retard the growth of ice crystals.

The art has long recognized a need for cold water soluble gelatin products. Unfortunately, it has been difficult until this time to achieve good solubility for gelatin in cold water. There is a growing demand for all categories of food products which can be fully prepared and ready for consumption in the shortest period of time. One area in particular where cold water solubility would be desirable is for the preparation of gelatin dessert mixes. The vast majority of gelatin dessert mixes which are currently available require the use of hot water to dissolve the gelatin and extended times, on the order of from about 2 to about 4 hours, to permit them to achieve the proper consistency for eating. Thus, these products are often viewed as inconvenient because they require the use of hot water and also because of the extended setting time before they can be enjoyed. Because of this, many consumers who enjoy eating gelatin desserts and salads prepared with them forego their use because they perceive them as too inconvenient.

Background art

This problem was recognized by Hagerty in US Patent 2,803,548 wherein he disclosed that a room-temperature soluble gelatin could be prepared by drying a gelatin solution at reduced pressure within a relatively narrow temperature range of between 37°C and 70°C. According to his procedure, an aqueous gelatin solution, preferably containing a sugar such as sucrose, was first prepared by heating and was then dried at the indicated temperatures at a pressure of from 50 to 100 millimeters of mercury (6.65 to 13.3 KPa). The disclosure emphasizes the need to dry at the indicated temperatures and states where dextrose or corn syrup are substituted for the sucrose, a dense, rather than fluffy, product is produced. While the patent suggests that the material is soluble in cold water, no specific details as to water temperature or time for solution are given. The patent does indicate, however, that gel strength of products prepared according to the disclosure are about 10% less than those prepared by conventional techniques.

In US Patent 2,948,622, Cahn discloses that a hot solution comprising about one part gelatin, nine parts sugar, and 10 parts water can be dried as a thin film, and that the dry product is soluble in cold tap water. Contrary to the disclosure of Hagerty, Cahn indicates that the temperature should be between 70°C and 120°C and the pressure should be near atmospheric. He indicates, however, that pressures down to about 0.75 atmospheres (76 kPa) can also be employed. While the exact conditions of dissolution of the final product in cold water are not given, it is indicated that the product of at least one example can be dissolved in cold water and then fully set by cooling for about 45 minutes at a temperature of 10°C.

In addition to the batch drying process of Hagerty and the atmospheric drum drying process of Cahn, these two workers together disclosed in US Patent 2,841,498 that a cold water soluble gelatin could be prepared by spray drying an aqueous solution of sucrose and gelatin, provided that the sucrose content was at least 8 times, and preferably on the order of 9 or 10 times, the gelatin content. This disclosure is very specific as to the need for sugar to be sucrose and that the sucrose be present in a specific concentration. While other sugars such as dextrose and corn syrup solids are disclosed, they are mentioned only for admixture with the spray dried product. Cahn and Hagerty disclose that after dissolving their product in cold water, it sets to a gel within between about 7 and 15 minutes when cooled to about 32°F (0°C) and a solution at 75°F (25°C) when placed in an ordinary kitchen refrigerator sets to a firm gel therein in about one and one-half hours. It is disclosed that the acid component can be included prior to drying if desired.

In Canadian Patent 896,965 to de Boer and US Patent 3,904,771 to Donnelly et al, there are described procedures for preparing various cold water soluble gelatin products by spray drying solutions comprising gelatin and an acid. Donnelly et al disclose that in addition to the acid which is employed at a level of from about 30 to 200% by weight of gelatin, the solution can contain a sugar such as fructose or sucrose prior to spray drying. In the Canadian patent, however, de Boer indicates that sugar can be eliminated from the spray drying solution where the acid is employed at a level of from about 5 to about 20% based upon the weight of the gelatin. According to de Boer, spray drying the dilutely acid gelatin solution permits the formation of fine droplets for enhanced drying.

According to the disclosure of Kalafatas in US Patent 3,927,221, the need for elaborate or extensive drying systems of the type described in US Patents 2,803,548, 2,841,498 and 2,948,622 can be obviated by the use of an extrusion process. According to this disclosure, the cold water soluble gelatin composition is prepared by subjecting a sugar/gelatin admixture to heat and pressure while applying shearing forces to the admixture in an extruder. The products are said to dissolve in water at about 50°F (10°C) after 2 minutes of spoon stirring. The solutions prepared in this manner are set after about two hours refrigeration, as compared to about four hours when hot water is used to dissolve conventional gelatin dessert mixes. The disclosure incidentally mentions the use of dispersants, wetting agents and emulsifiers to enhance

2

dispersibility. Similarly, US Patent 2,819,970 to Steigmann and US Patent 2,819,971 to Gunthardt also mention the use of additives of this type.

US Patent 3,362,830 to Addesso is concerned with preparing a foam of an aqueous sugar and gelatin mixture and drying the foam. However, the specification at column 3 lines 59—62 very clearly states that · using ratios of sugar to gelatin of 7:1 or less significantly adversely affects the cold water solubility of the end product. Further, Addesso calls for the use of sucrose as the sugar normally employed and does not disclose the use of a combination of corn syrup solids and maltodextrin.

British Patent 1,419,966 is directed to the preparation of a dessert composition resembling yogurt. There is a reference to the use of cold water soluble gelatin as an ingredient of the dessert mix. At page 2 beginning at line 14 there is reference to a particular cold water soluble gelatin which is commercially available and comprises a spray dried mixture of corn syrup solids and a lime ossein gelatin but no details are given as to the exact method of preparation of this product.

Disclosure of the invention

The present invention provides a process for preparing a cold water soluble gelatin product, the product of that process and a gelatin dessert mix which is fully soluble in cold water. The process according to the invention comprises: preparing an aqueous solution at elevated temperature, the solution comprising gelatin, sugar, at least the major proportion of which is a combination of corn syrup solids having a DE of 42 or less and maltodextrin, the ratio of sugar to gelatin being in the range from 3:1 to 7:1, an acid and a surface active agent, and drying the solution, the amount of the surface active agent being effective to increase the dispersibility of the dried product in cold water. According to one preferred aspect of the process, the solution comprising gelatin and sugar has a total solids content and ratio of sugar to gelatin effective to form a foam, is extruded under conditions effective to provide a foam; and then dried. According to another preferred aspect of the invention, the aqueous solution comprising gelatin and sugar is applied to a surface in a thin layer, dried by heating the surface under an absolute pressure of less than 5 inches of mercury (16.7 kPa), and the resulting dried material is then removed from the surface. The product of this process is useful in all applications where cold water solubility would be advantageous, and it is particularly useful in the preparation of gelatin dessert mixes which are fully soluble in cold water. The dessert mixes according to the present invention include acid, buffer, flavor and color, in addition to the cold water soluble gelatin prepared according to the process of the invention.

The following description discloses a cold water soluble gelatin which can be rapidly completely dissolved in cold tap water to provide a clear, high quality gelatin product of good strength and high quality in a conveniently short period of time, and a commercially efficient process for preparing it. Desirably the product is a gelatin dessert mix which can be fully dissolved in tap water at 55°F (12.8°C) with one minute of spoon stirring and then set for a high quality dessert in a conveniently short period of refrigeration.

Detailed description of the preferred embodiments

The cold water soluble gelatin product prepared according to the present invention finds particular utility in gelatin dessert mixes, and will therefore be described in this environment as exemplary. This is not meant to imply, however, that other applications of the product are not intended. In fact, the products of the invention will be very useful in the preparation of salad dressings, ice cream, cake and pie mixes which require no baking, candies, and a wide variety of food products which currently employ gelatin or gelatin-like materials.

As a matter of definition, the term "cold water soluble" as used in the present application will be intended to mean that the product can be dissolved in water at 55°F (12.8°C) at the indicated concentration of usage. Preferably, this is accomplished in less than 5 minutes, and preferably less than 1 minute, by stirring with a spoon to provide moderate agitation. However, some formulations require high shear mixing, such as in a kitchen blender. Also by way of definition, all parts and percentages used throughout this disclosure are on a weight to weight basis, unless the contrary is indicated at the point of usage.

The particular type of gelatin employed is selected primarily upon the intended use of the ultimate product, and not for any particular functionality of the gelatin within the process of the invention. Therefore, the cold water soluble gelatin products of this invention can be prepared from gelatins of either the Type A (acid) or Type B (alkali) forms. Similarly, the gelatin can be prepared from any collagen source including bone, hide and other collagen sources and can be derived from any suitable animal, including beef and pork sources. Where the cold water soluble gelatin of the invention is intended for use in gelatin dessert mixes, the gelatin will preferably be a pork Type A gelatin. The bloom will typically be within the range of from 150 to 275.

According to the process, an aqueous solution comprising gelatin and sugar is dried, preferably under reduced pressure or other conditions effective to provide a low density product. While any apparatus capable of performing the drying operation can be employed, vacuum drum dryers, spray dryers capable of drying foams, extruders capable of forming foams in conjunction with drying ovens, and the like, are preferred. These dryers should be capable of handling high volumes of material at practical solids concentrations to achieve rapid drying.

The term "sugar" as it is employed in the present context is to be understood as meaning any of a number of useful saccharide materials which are capable of being dried under the conditions of processing to provide a degree of cold water solubility. Preferences for a specific material based upon its affinity for water or its contribution to the sweetness or the texture of the final product will control the final selection. Included in the list of useful sugars are monosaccharides, disaccharides, and polysaccharides and their degradation products; e.g., pentoses, including aldol pentoses, methyl pentoses, keto pentoses, like xylose and arabinose; a dioxy aldoses like rhamnose, hexoses and reducing saccharides such as aldo hexoses like glucose, galactose and mannose; and keto hexoses, like fructose and sorbose; disaccharides, like lactose and maltose; non-reducing disaccharides such as sucrose; and other polysaccharides such as raffinose.

At least the major proportion of the sugar used in the process is a mixture of maltodextrin and corn syrup solids which are products derived from the hydrolysis of starch, typically corn starch. As known to the art, corn syrups are generally those materials with DE values of 28 and greater, while maltodextrins will have DE values of from 13—23. However, the art also includes lower DE materials within the term maltodextrin. Thus corn dextrins having DE values of 1—13 are often included within this term and the present invention uses it accordingly. Also, materials with DE values between 23 and 28 are includable under either group. Corn syrup solids having DE values of 42 and below are used in the process. Desirably, the ratio of the weight of corn syrup solids to maltodextrins will be within the range of from 1:9 to 9:1.

To prepare the solution for drying, the gelatin and sugar (preferably syrup solids and maltodextrin) are heated in the desired concentration in water, preferably to a temperature of 150 to 160°F (65.5 to 71°C) to achieve complete solution. Typically, this is conducted by dissolving the gelatin in water first and then adding the corn syrup solids, and finally adding the maltodextrin to the solution. Advantageously, a gelatin solution from a gelatin production process, typically containing 15 to 20% gelatin can be mixed with dry sugars including corn syrup solids and maltodextrin or concentrated solutions of either or both of these to achieve the desired concentration. The gelatin concentration will typically be within the range of from 5 to 25%, and the combined weight sugars including corn syrup solids and maltodextrin will typically be within the range of from 20 to 80%, these percentages based on the weight of the total solution. The ratio of the total weight of corn syrup solids and maltodextrin and other sugars to gelatin will be within the range of from 3—7:1. The total solids concentration of the solution for drying, including these and any other solid materials, will typically be within the range of from 20 to 95%. The concentrations will be toward the high end of the range where foaming is desired. More preferred total solids concentrations, where foaming is not desired will be from 30 to 70%.

In addition to the corn syrup solids and maltodextrins, other sugars may be employed. However, the corn syrup solids and maltodextrin together comprise at least a major proportion of the sugars.

In addition to the gelatin and the sugars, the aqueous solution for drying also comprises an acid suitable for food use such as fumaric, citric, malic, adipic, ascorbic, tartaric, succinic, and phosphoric acids. Among these, fumaric and adipic acids are preferred. The acid is found to improve final product solubility and will typically be present in a ratio of acid to gelatin within the range of from 0.05—0.5:1. More preferred ratios of acid to gelatin will be within the range of from 0.18—0.28:1 and significantly improve product solubility and can provide all the acid that is required for a good tasting gelatin dessert. It may sometimes also be desirable to employ a suitable buffer such as a sodium or potassium salt of any of the above mentioned acids. Preferably, the acid is added to the gelatin solution prior to adding the corn syrup solids and maltodextrin. The pH may be adjusted to within the range of from 3 to 4.5 by use of the buffering salts.

According to the invention, the solution prior to drying will also contain a surface-active agent, such as those known generically to the art as polysorbates, hydroxylated lecithin, acetylated monoglycerides, succinylated monoglycerides, ethoxylated mono- and diglycerides, sodium stearoyl 2-lactylate and the like. These surface-active agents will be employed in amounts effective to render the dried product more easily dispersible in cold water. Exemplary of the polysorbate surface-active agents are polysorbate 60, polysorbate 65 and polysorbate 80. Polysorbate 60 is identified chemically as polyoxyethylene (20) sorbitan monostearate while polysorbate 65 is known as polyoxyethylene (20) sorbitan tristearate, and polysorbate 80 is known as polyoxyethylene (20) sorbitan monooleate. In addition to these materials, other surface-active agents which have the ability of increasing the dispersibility of the final product in cold water can also be employed. While the exact level of addition will be controlled based upon a balance between cost, effectiveness and taste, it is preferred to maintain the level within the range of from 0.05 to 7% based upon the weight of the gelatin to provide the desired degree of improvement in dispersibility without adversely affecting the ultimate rate of set or gel strength of the cold water soluble gelatin product produced according to the process of the invention.

After preparing the aqueous solution comprising gelatin, sugar, and any additional materials desired according to the above disclosure, the solution is then dried e.g. by vacuum drum drying, spray drying conventionally or in the form of a foam, extrusion of a foam followed by drying, or by other suitable means which preferably produce a low density product.

In vacuum drum drying, the solution is applied in a thin layer to the surface of a suitable dryer, such as the Buflovak double drum vacuum drum dryer or vacuum drum dryer of similar type. Typically, the thickness of the layer will be within the range of from 0.1 to 2.0 millimeters. The surface of the dryer is preferably heated from the reverse side by steam to a temperature effective for drying the solution within a commercially practical period of time while maintaining the gelatin in the amorphous state. Typically, the residence time of the solution on the drying surface from the time of application to the time of complete drying will be from 1 minute to 5 minutes, preferably from 90 seconds to 2.5 minutes. Steam at a pressure of from 10 to 60 psig (69 to 414 kPa) will be effective for supplying adequate heat. More typically, the steam pressure will be within the range of from 15 to 30 psig (103 to 206 kPa).

The solution is dried on the vacuum drum drying surface under a reduced pressure. Absolute pressures of less than 5 inches of mercury (169 kPa) are effective. The reduced pressure causes rapid volatilization of the water within the solution and creates a light, friable, flaky product which exhibits good cold water solubility immediately after removal from the surface by means of a knife-edged scraper blade or other suitable means. It is preferred, however, to further reduce and classify the particle size of the dried cold water soluble gelatin product to a more uniform size such as by grinding and screening. The dried material is preferably ground and classified to a particle size of from 12 to 100 US series mesh (1.68 to 0.149 mm openings).

According to another embodiment, the aqueous solution comprising gelatin, sugar, and any additional materials desired according to the above disclosure, the solution is extruded as a foam and dried. The foam can be prepared by dispersing a gas within the solution prior to extrusion such that a foam is produced, or the solution can be subjected to mechanical shearing under conditions of heat and elevated pressure effective to cause expansion of the solution due to rapid volatilization of water upon exiting the closed extruder system to the atmosphere or other area having a suitably-controlled pressure to permit expansion.

According to one variation of this embodiment, the air, nitrogen, carbon dioxide or other suitable gas is aspirated into a process line containing a solution of sugar and gelatin. Then, the gas is dispersed within the solution in a manner known to the art. For example, the solution containing the gas may be passed through a gear pump which disperses the air to some extent while increasing the pressure applied to the solution. From the gear pump, the solution may then be passed through a homogenizer of the type employed in the dairy industry. Typical of these are the Manton Gaulin and Cherry Burrell two-stage homogenizers. Alternatively, a high shear in-line mixing device can be employed. The particular operating conditions for these devices will be affected by the temperature of the solution as well as its total solids content, the ratio of sugar to gelatin, the presence of surface-active agents, acids, and other materials. After finely dispersing the gas within the solution, the solution can be foamed in the process line prior to exiting an extrusion orifice or it can be foamed upon exit.

According to one desirable embodiment, a spray dryer nozzle is employed to extrude the solution as a foam into finely dispersed particles. The dispersed droplets are then spray dried in conventional manner. Thus, drying air can be administered either co-currently or countercurrently with the particles of foam solution.

According to another embodiment, the solution is subjected to mechanical shear under conditions of heat and pressure within a closed system, such as that provided within an extruder designed for preparing foamed plastic materials. While it is possible to employ a liquid more volatile than water to rapidly volatilize and cause the foaming action as is accomplished in the plastics industry, the water within the solution itself is effective to provide adequate expansion. To achieve expansion, the temperature and pressure within the extruder are selected at suitable levels based upon the composition of the solution in terms of total solids, the ratio of sugar to gelatin, and the presence of other materials, to enable the water to flash off as steam upon exiting the high pressure conditions of the extruder. This flashing results in the spontaneous foaming, partial drying, and cooling of the solution as it exits the extruder. Because of the great number of variables within the solution itself, as well as in the design of conventional extruders, there is no universal set of operating ranges which can be identified as defining the operable limits according to this embodiment; however, those skilled in the art of extruding foam materials will readily be able to adapt the particular equipment desired to the preparation of foam gelatin.

After preparation of the foamed solution of gelatin and water by any of the methods above or any other suitable methods, the extruded foam is dried to a moisture content suitable for packaging or other processing. This can be achieved by the use of conventional drying ovens, such as a Proctor and Schwartz dryer. Desirably, the moisture content of the solution is controlled prior to extrusion to provide an extruded foam which is sufficiently shape retaining to permit its immediate sub-division prior to drying, to thereby speed the drying process. Alternatively, the extruded foam can be dried in stages, the first stage reducing the moisture contents sufficiently to permit sub-division, and a second and any subsequent stage being employed to provide the final drying to the desired moisture content.

Preferred bulk densities for the dry cold water soluble gelatin product of the invention will be within the range of from 0.15 to 0.40 grams per cubic centimeter.

The dried cold water soluble gelatin product prepared according to the process of the invention can be compounded with other typical ingredients of dry gelatin dessert mixes to prepare a gelatin dessert mix which is, itself, cold water soluble. Typically, the dry gelatin dessert mix prepared according to the invention will comprise the cold water soluble gelatin plus additional amounts of sweeteners, acidulents, buffers, flavors, and colors for the desired effect in the final product. Where these materials are not added to the solution prior to drying, they can be added by dry mixing with the cold water soluble gelatin product after drying by simple dry blending or by blending and agglomeration. Typically where the sugar is sucrose, the ratio of sucrose to gelatin will be within the range of from about 9—15:1. And, where the acid is fumaric acid, the ratio of acid to gelatin will be within the range of from about 0.18—0.30:1. The buffer will preferably be employed in an amount effective to adjust the pH of the final product to within the range of from 3 to 4.5. The flavorants and colorants are used in widely varying amounts, depending upon the desired end effect. The cold water soluble gelatin dessert can also contain vitamin and mineral supplements if desired.

Example 1

This example describes the preparation of a cold water soluble gelatin product according to the invention. A solution for drying is prepared by admixing the following materials:

| Ingredients | Parts |
| --- | --- |
| Corn syrup solids, 42 DE | 333 |
| Maltodextrin, 20 DE | 333 |
| Pork gelatin, Type A, 250+bloom | 111 |
| Fumaric acid | 28 |
| Polysorbate 60 | 7.28 |
| Water | 650 |

The above ingredients are mixed and heated in a kettle for 10 minutes at 155°F (68.3°C) while agitating by a Lightnin Mixer. The resulting solution is cooled to 115°F (46°C) and held at this temperature. The solution, having a 60% solids content, is applied in a thin film to the inside surface of a jacketted vacuum kettle which is heated by introducing steam at a pressure of 20 psig (138 kPa) to the jacket. The kettle is closed and the vacuum, indicated by the pressure gauge to be complete, is applied until the product becomes dried to a low-density, flaky consistency after 90 seconds to 2.5 minutes. The dried material is then scraped from the surface on the inside of the kettle and the process is repeated until a sufficient quantity of cold water soluble gelatin product is obtained.

Example 2

This example illustrates the preparation of a cold water soluble dry gelatin dessert mix according to the present invention. The following ingredients are admixed:

| Ingredients | Parts |
| --- | --- |
| Cold water soluble gelatin of Example 1 | 46.88 |
| Sucrose | 36.64 |
| Sodium citrate buffer | 1.30 |
| Spray dried flavor | 0.16 |
| FD & C color | 0.04 |
| Ascorbic acid | 0.03 |

These materials are dry blended to provide a homogeneous blend to provide the cold water soluble dry gelatin dessert mix. A gelatin dessert is prepared by adding 16 fluid ounces (473 cm$^3$) of water to a container containing 85 grams of the cold water soluble dessert mix prepared above and stirring for 1 minute with a spoon.

Example 3

The procedure of Example 1 is repeated, but this time the solution is adjusted to a solids content of 30% and is spray dried in a Niro Atomizer Pilot Model Spray Dryer. The solution is sprayed using a Centrifugal nozzle at a rate of 1.5 pounds (0.68 Kg) per hour. The air inlet temperature is about 175°C and the outlet temperature is about 103°C. When combined with the other ingredients for a gelatin dessert mix, as in Example 2, essentially complete solution in cold water is achieved after mixing in a kitchen blender.

Example 4

The procedure of Example 1 is repeated, but this time employing sucrose as the sugar and not employing an acid in the solution for drying. When combined with the other ingredients for a gelatin dessert mix, including the acid in dry form, and mixed with water as in Example 2, essentially complete solution in cold water is achieved after 5 minutes of spoon stirring.

Example 5

This example describes the preparation of a cold water soluble gelatin product according to the invention. A solution for drying is prepared by admixing the following materials:

| Ingredients | Parts |
| --- | --- |
| Corn syrup solids, 42 DE | 333 |
| Maltodextrin, 20 DE | 333 |
| Pork gelatin, Type A, 250+bloom | 111 |
| Fumaric acid | 28 |
| Polysorbate 60 | 7.28 |
| Water | 650 |

The above ingredients are mixed and heated in a kettle for 10 minutes at 155°F (68.3°C) while agitating by a Lightnin Mixer. The resulting solution is cooled to 115°F (46°C) and maintained at that temperature for further processing. The solution, having an 85% solids content, is passed through a line having an aspirator nozzle position therein. A volume of air equal to the volume of solution under the conditions present within the line is introduced therein. The solution containing the air is then passed through a gear pump which increases the pressure within the line to about 50 psig (345 kPa). From the gear pump, the solution containing air dispersed therein is passed through a single-stage homogenization in a Manton Gaulin homogenizer operating at a pressure of 500 psig (3447 kPa). The solution exiting the homogenizer has air finely dispersed throughout. This solution containing the dispersed air is then passed through a Votator scraped-surface heat exchanger wherein the temperature is reduced to about 70°F (21°C) and the solution is then extruded as a foam from the exit end of the votator scraped-surface heat exchanger. This material is then dried in a convection oven being careful to avoid melting the product.

Example 6

This example illustrates the preparation of a cold water soluble dry gelatin dessert mix according to the present invention. The following ingredients are admixed:

| Ingredients | Parts |
| --- | --- |
| Cold water soluble gelatin of Example 5 | 46.88 |
| Sucrose | 36.64 |
| Sodium citrate buffer | 1.30 |
| Spray dried flavor | 0.16 |
| FD & C color | 0.04 |
| Ascorbic acid | 0.03 |

These materials are dry blended to provide a homogeneous blend to provide the cold water soluble dry gelatin dessert mix. A gelatin dessert is prepared by adding 16 fluid ounces (473 cm³) of water to a container containing 85 grams of the cold water soluble dessert mix prepared above and stirring.

Example 7

The procedure of Example 5 is repeated, but this time employing sucrose as the sugar and not employing an acid in the solution. The foamed product is mixed with the other ingredients for a gelatin dessert mix, including the acid in dry form, and mixed with water as in Example 6.

Example 8

This example describes the preparation of a low density cold water soluble gelatin product by spray drying an extruded foam in accordance with the invention. To accomplish this, a solution is prepared according to the formulation and procedure described in Example 5. The solution is then aerated also in the manner described in Example 5. The aerated solution is then finely dispersed through a Swenson nozzle in a Swenson spray dryer into a co-current stream of air having an inlet temperature of about 300°F (149°C) and an outlet temperature of about 200°F (93.3°C).

Example 9

This example describes the preparation of a foamed low density cold water soluble gelatin product by the use of a high pressure extruder. The solution, according to this example, is prepared in the same manner as in Example 5 except that the water content is reduced to provide a total solids content of about 90%. The solution is fed to a Braebender extruder wherein it is heated under conditions of elevated temperature and pressure which cause the product to exit the extruder at a temperature of about 210°F (99°C) in a highly expanded foam. The resulting foamed solution is then dried in a Proctor and Schwartz convection dryer.

**Claims**

1. A process for preparing a cold water soluble gelatin product, comprising: preparing an aqueous

7

solution at elevated temperature, the solution comprising gelatin, sugar, at least the major proportion of which is a combination of corn syrup solids having a DE of 42 or less and maltodextrin, the ratio of sugar to gelatin being in the range from 3:1 to 7:1, an acid and a surface active agent, and drying the solution, the amount of the surface active agent being effective to increase the dispersibility of the dried product in cold water.

2. A process according to claim 1 wherein the acid is fumaric acid.

3. A process according to claim 1 or 2 wherein the surface-active agent comprises a member selected from the group consisting of polyoxyethylene (20) sorbitan monostearate, polyoxyethylene (20) sorbitan monooleate, polyoxyethylene (20) sorbitan tristearate, and mixtures of these.

4. A process according to any preceding claim wherein the dried material is ground and screened to a particle size of from 12 to 100 US series mesh (1.68 to 0.149 mm openings).

5. A process according to any preceding claim wherein the bulk density of the cold water soluble gelatin product is within the range of from 0.15 to 0.40 grams per cubic centimeter.

6. A process according to any preceding claim wherein the sugar additionally comprises sucrose.

7. A process according to any preceding claim wherein the ratio of the acid to the gelatin is within the range of from 0.05 to 0.5:1.

8. A process according to claim 7 wherein the ratio of acid to gelatin is within the range of from 0.18 to 0.28:1.

9. A process according to any preceding claim wherein the solution prior to drying comprises from 20 to 95% solids.

10. A process according to any one of claims 1 to 8 wherein the aqueous solution has a total solids content and ratio of sugar to gelatin effective to form a foam and the solution is extruded under conditions effective to provide a foam, and the foam is dried.

11. A process according to claim 10 wherein a gas is incorporated into the solution prior to extrusion.

12. A process according to claim 10 or 11 wherein the gas is uniformly dispersed in the solution and the solution is then passed through a homogenizer to finely disperse the gas within the solution.

13. A process according to claim 10, 11 or 12 wherein the foam is extruded through a spray nozzle and then spray dried.

14. A process according to any one of claims 10—13 wherein the solution is mechanically sheared under conditions of heat and elevated pressure within a closed system and is then extruded into an area maintained at a pressure sufficiently lower than that within the closed system to cause expansion of the solution upon extrusion.

15. A process according to any one of claims 10—14 wherein the moisture content of the solution is controlled effectively to provide an extruded foam which is sufficiently shape retaining to permit sub-dividing prior to drying, and wherein the extruded foam is sub-divided prior to drying.

16. A process according to any one of claims 10—15 wherein the solution prior to drying comprises from 30 to 95% solids.

17. A process according to any one of claims 1—10 wherein the solution is spray dried.

18. A process according to any preceding claim wherein the solution is dried in a thin film under a partial vacuum.

19. A process according to claim 18 wherein the drying step is accomplished by applying a thin layer of the aqueous solution to a surface, heating the surface under an absolute pressure of less than 5 inches of mercury (16.9 kPa), and removing the resulting dried material from the surface.

20. A process according to claim 19 wherein the solution prior to drying comprises from 30 to 70% solids.

21. A process according to any preceding claim wherein a buffer, a flavor, and a color are incorporated in the gelatin product to provide a gelatin dessert mix.

22. A process according to claim 21 wherein the buffer is employed in an amount effective to adjust the pH of an aqueous solution of the gelatin dessert mix to a pH within the range of from 3 to 4.5.

23. A process according to claim 21 or 22 wherein additional sugar is admixed to bring the total sugar to gelatin ratio within the range of from 9 to 15:1.

24. A process according to any one of claims 21—23 wherein the gelatin dessert mix is capable of completely dissolving in 55°F (12.8°C) water in less than one minute by stirring with a spoon.

25. A process according to any preceding claim wherein the weight ratio of corn syrup solids to maltodextrin is from 1:9 to 9:1.

**Patentansprüche**

1. Verfahren zur Herstellung eines in kaltem Wasser löslichen Gelatineproduktes, umfassend: Herstellen einer wässrigen Lösung bei erhöhter Temperatur, wobei die Lösung Gelatine und Zucker enthält, zumindest der Großteil davon eine Kombination aus Getreidesirupfeststoffen mit einem Dextroseäquivalent von 42 oder weniger und Maltodextrin ist, und das Verhältnis von Zucker zu Gelatine im Bereich von 3:1 und 7:1 liegt, und weiters eine Säure und einen grenzflächenaktiven Stoff enthält, und Trocknen der Lösung wobei die Menge des grenzflächenaktiven Stoffes eine Erhöhung des Dispersionsvermögens des getrockneten Produktes in kaltem Wasser bewirkt.

# 0 087 317

2. Verfahren nach Anspruch 1, dadurch gekennzeichnet, daß die Säure Fumarsäure ist.

3. Verfahren nach Anspruch 1 oder 2, dadurch gekennzeichnet, daß der grenzflächenaktive Stoff einen Bestandteil der Gruppe Polyoxyethylen(20)sorbitanmonostearat, Polyoxyethylen(20)sorbitanmonooleat, Polyoxyethylen(20)sorbitantristearat und Mischungen derselben umfaßt.

4. Verfahren nach einem der vorhergehenden Ansprüche, dadurch gekennzeichnet, daß das getrocknete Material gemahlen und auf eine Teilchengröße zwischen 12 und 100 U.S.mesh-Werten (1,68 bis 0,149 mm Öffnungen) gesiebt wird.

5. Verfahren nach einem der vorhergehenden Ansprüche, dadurch gekennzeichnet, daß die Schüttdichte des in kaltem Wasser löslichen Gelatineproduktes im Bereich zwischen 0,15 und 0,40 Gramm pro Kubikzentimeter liegt.

6. Verfahren nach einem der vorhergehenden Ansprüche, dadurch gekennzeichnet, daß der Zucker zusätzlich Saccharose enthält.

7. Verfahren nach einem der vorhergehenden Ansprüche, dadurch gekennzeichnet, daß das Verhältnis von Säure zu Gelatine im Bereich von 0,05 bis 0,5:1 liegt.

8. Verfahren nach Anspruch 7, dadurch gekennzeichnet, daß das Verhältnis von Säure zu Gelatine im Bereich von 0,18 bis 0,28:1 liegt.

9. Verfahren nach einem der vorhergehenden Ansprüche, dadurch gekennzeichnet, daß die Lösung vor dem Trocknen 20 bis 95% Feststoffe enthält.

10. Verfahren nach einem der Ansprüche 1 bis 8, dadurch gekennzeichnet, daß die wässrige Lösung einen solchen Gesamtfeststoffgehalt und ein solches Verhältnis von Zucker zu Gelatin aufweist, daß eine Schaumbildung bewirkt wird, die Lösung unter Bedingungen extrudiert wird, die eine Schaumbildung bewirken, und der Schaum getrocknet wird.

11. Verfahren nach Anspruch 10, dadurch gekennzeichnet, daß ein Gas in die Lösung vor dem Extrudieren eingeführt wird.

12. Verfahren nach Anspruch 10 oder 11, dadurch gekennzeichnet, daß das Gas in der Lösung gleichmäßig dispergiert wird und die Lösung dann durch einen Homogenisator geführt wird, sodaß das Gas in der Lösung fein dispergiert wird.

13. Verfahren nach Anspruch 10, 11 oder 12, dadurch gekennzeichnet, daß der Schaum durch eine Sprühdüse extrudiert und dann sprühgetrocknet wird.

14. Verfahren nach einem der Ansprüche 10 bis 13, dadurch gekennzeichnet, daß die Lösung in einem geschlossenen System unter Hitzebedingungen und erhöhten Druckbedingungen einer Scherwirkung ausgesetzt und dann in einen Bereich extrudiert wird, der unter einem Druck steht, der ausreichend niedriger ist als der im geschlossenen System, um eine Expansion der Lösung beim Extrudieren zu bewirken.

15. Verfahren nach einem der Ansprüche 10 bis 14, dadurch gekennzeichnet, daß der Feuchtigkeitsgehalt der Lösung so eingestellt wird, daß ein Schaum entsteht, der ausreichend formstabil ist, um vor dem Trocknen ein Unterteilen zu ermöglichen, und daß der extrudierte Schaum vor dem Trocknen geteilt wird.

16. Verfahren nach einem der Ansprüche 10 bis 15, dadurch gekennzeichnet, daß die Lösung vor dem Trocknen 30 bis 95% Feststoffe enthält.

17. Verfahren nach einem der Ansprüche 1 bis 10, dadurch gekennzeichnet, daß die Lösung sprühgetrocknet wird.

18. Verfahren nach einem der vorhergehenden Ansprüche, dadurch gekennzeichnet, daß die Lösung zu einem dünnen Film unter einem Teilvakuum getrocknet wird.

19. Verfahren nach Anspruch 18, dadurch gekennzeichnet, daß eine dünne Schicht der wässrigen Lösung auf eine Fläche aufgebracht wird, die Fläche unter einem absoluten Druck von weniger als 5 Zoll Quecksilbersäule (16,7 kPa) erhitzt und das entstehende getrocknete Material von der Fläche entfernt wird.

20. Verfahren nach Anspruch 19, dadurch gekennzeichnet, daß die Lösung vor dem Trocknen 30 bis 70% Feststoffe enthält.

21. Verfahren nach einem der vorhergehenden Ansprüche, dadurch gekennzeichnet, daß eine Puffersubstanz, ein Geschmacksstoff und eine Farbe in das Gelatineprodukt so eingearbeitet werden, daß eine Gelatinedessertmischung entsteht.

22. Verfahren nach Anspruch 21, dadurch gekennzeichnet, daß eine Puffersubstanz in einer solchen Menge verwendet wird, daß der pH-Wert einer wässrigen Lösung des Gelatinedesserts einen pH-Wert im Bereich von 3 bis 4,5 erreicht.

23. Verfahren nach Anspruch 21 oder 22, dadurch gekennzeichnet, daß der zusätzliche Zucker beigemischt wird, sodaß das Gesamtverhältnis Zucker zu Gelatine im Bereich von 9 zu 15:1 liegt.

24. Verfahren nach einem der Ansprüche 21 bis 23, dadurch gekennzeichnet, daß die Gelatinedessertmischung sich in Wasser mit 55°F (12,8°C) in weniger als einer Minute unter Rühren mit einem Löffel vollständig löst.

25. Verfahren nach einem der vorhergehenden Ansprüche, dadurch gekennzeichnet, daß das Gewichtsverhältnis von Getreidesirupfeststoffen zu Maltodextrin zwischen 1:9 und 9:1 beträgt.

**Revendications**

1. Un procédé pour la préparation d'un produit à base de gélatine soluble dans l'eau froide

9

comprenant: la préparation d'une solution aqueuse à température élevée, la solution comprenant de la gélatine, du sucre, dont au moins une proportion majeure est une combinaison de sirop de glucose déshydraté ayant un ED de 42 ou moins et de maltodextrine, le rapport du sucre à la gélatine étant dans la gamme de 3:1 à 7:1, un acide et un agent tensio-actif, et le séchage de la solution, la quantité d'agent tensio-actif étant efficace pour accroître la dispersibilité dans l'eau froide du produit séché.

2. Un procédé selon la revendication 1 dans lequel l'acide est l'acide fumarique.

3. Un procédé selon la revendication 1 ou 2 dans lequel l'agent tensio-actif comprend un composant choisi dans le groupe constitué par le polyoxyéthylène(20)monostéarate de sorbitane, le polyoxy-éthylène(20)monooléate de sorbitane, le polyoxyéthylène(20)tristéarate de sorbitane et leurs mélanges.

4. Un procédé selon l'une quelconque des revendications précédentes dans lequel la matière séchée est broyée et tamisée à une taille des particules de 12 à 100 mesh selon la série US (ouvertures de 1,68 à 0,149 mm).

5. Un procédé selon l'une quelconque des revendications précédentes dans lequel la masse volumique apparente du produit à base de gélatine soluble dans l'eau froide est dans la gamme de 0,15 à 0,40 g/cm³.

6. Un procédé selon l'une quelconque des revendications précédentes dans lequel le sucre contient de plus du saccharose.

7. Un procédé selon l'une quelconque des revendications précédentes dans lequel le rapport de l'acide à la gélatine est dans la gamme de 0,05 à 0,5:1.

8. Un procédé selon la revendication 7 dans lequel le rapport de l'acide à la gélatine est dans la gamme de 0,18 à 0,28:1.

9. Un procédé selon l'une quelconque des revendications précédentes dans lequel la solution avant séchage contient de 20 à 95% de matières sèches.

10. Un procédé selon l'une quelconque des revendications 1 à 8 dans lequel la solution aqueuse a une teneur totale en matières sèches et un rapport du sucre à la gélatine efficaces pour former une mousse et la solution est extrudée dans des conditions efficaces pour former une mousse et la mousse est séchée.

11. Un procédé selon la revendication 10 dans lequel un gaz est incorporé à la solution avant l'extrusion.

12. Un procédé selon la revendication 10 ou 11 dans lequel le gaz est dispersé uniformément dans la solution et la solution est ensuite conduite à travers un homogénéisateur pour disperser finement le gaz dans la solution.

13. Un procédé selon la revendication 10, 11 ou 12 dans lequel la mousse est extrudée à travers une buse de pulvérisation puis séchée par pulvérisation.

14. Un procédé selon l'une quelconque des revendications 10 à 13 dans lequel la solution est soumise à un cisaillement mécanique dans des conditions de chaleur et de pression élevées dans un système clos puis extrudée dans une zone maintenue à une pression suffisamment inférieure à celle du système clos pour provoquer l'expansion de la solution lors de l'extrusion.

15. Un procédé selon l'une quelconque des revendications 10 à 14 dans lequel la teneur en humidité de la solution est ajustée de façon efficace pour fournir une mousse extrudée qui conserve suffisamment sa forme pour permettre sa subdivision avant le séchage et dans lequel la mousse extrudée est subdivisée avant le séchage.

16. Un procédé selon l'une quelconque des revendications 10 à 15 dans lequel la solution avant séchage contient 30 à 95% de matières sèches.

17. Un procédé selon l'une quelconque des revendications 1 à 10 dans lequel la solution est séchée par pulvérisation.

18. Un procédé selon l'une quelconque des revendications précédentes dans lequel la solution est séchée en une pellicule mince sous vide partiel.

19. Un procédé selon la revendication 18 dans lequel le stade de séchage est effectué par application d'une couche mince de la solution aqueuse à une surface, chauffage de la surface sous une pression absolue inférieure à 5 inches de mercure (16,9 kPa) et séparation de la matière séchée obtenue d'avec la surface.

20. Un procédé selon la revendication 19 dans lequel la solution avant le séchage contient 30 à 70% de matières sèches.

21. Un procédé selon l'une quelconque des revendications précédentes dans lequel un tampon, un arôme et un colorant sont incorporés au produit à base de gélatine pour fournir un mélange pour entremets à la gélatine.

22. Un procédé selon la revendication 21 dans lequel le tampon est employé en une quantité efficace pour ajuster le pH d'une solution aqueuse du mélange pour entremets à la gélatine à un pH compris dans la gamme de 3 à 4,5.

23. Un procédé selon la revendication 21 ou 22 dans lequel du sucre additionnel est mélangé pour porter le rapport du sucre total à la gélatine dans la gamme de 9 à 15:1.

24. Un procédé selon l'une quelconque des revendications 21 à 23 dans lequel le mélange pour entremets à la gélatine est capable de se dissoudre complètement dans l'eau à 55°F (12,8°C) en moins d'une minute par agitation avec une cuillère.

25. Un procédé selon l'une quelconque des revendications précédentes dans lequel le rapport pondéral du sirop de glucose déshydraté à la maltodextrine est de 1:9 à 9:1.

10